# EUROPÄISCHE PATENTSCHRIFT

(11) **EP 0 347 970 B1**
(45) Veröffentlichungstag und Bekanntmachung des Hinweises auf die Patenterteilung: **16.02.1994**
(21) Anmeldenummer: 89201501.7
(22) Anmeldetag: 12.06.1989
(51) Int. Cl.: G11C 29/00

(54) **Verfahren zum Prüfen eines Festwertspeichers und Anordnung zur Durchführung des Verfahrens**
Read-only memory test method, and device for carrying out the method
Procédé de test de mémoire morte et dispositif de mise en application dudit procédé

(30) Priorität: 18.06.1988 DE 3820728
(43) Veröffentlichungstag der Anmeldung: 27.12.1989
(73) Patentinhaber: Philips Patentverwaltung GmbH, 22335 Hamburg (DE); Philips Electronics N.V., 5621 BA Eindhoven (NL)
(72) Erfinder: Albertsen, Hans-Gerd, D-2000 Hamburg 61 (DE)
(74) Vertreter: Poddig, Dieter, Dipl.-Ing.

(56) Entgegenhaltungen:
- EP-A- 0 215 464
- ELECTRONIC DESIGN, Band 32, Nr. 5, 1983, Seiten 129-134; R. BHATNAGAR et al.: "Microcomputer's memories solve testing and firmware problems"
- PATENT ABSTRACTS OF JAPAN, Band 6, Nr. 84 (P-117)[962], 22. Mai 1982;& JP-A-57 21 000
- INTERNATIONAL TEST CONFERENCE ON INTEGRATION OF TEST WITH DESIGN AND MANUFACTURING, Washington, DC, 1.-3. September 1987, Seiten 826-832, IEEE, New York, US; L. BASTO et al.: "Testing the MC68030 caches"

## Beschreibung

Die Erfindung betrifft ein Verfahren zum Prüfen des Inhalts eines Festwertspeichers in einer integrierten Schaltung, die ferner einen durch den Inhalt des Festwertspeichers gesteuerten Prozessor mit einer Recheneinheit und einem Speicherregister enthält, wobei der Prozessor mit Außenanschlüssen der integrierten Schaltung verbunden ist und in einen Prüfmodus schaltbar ist, in dem der Inhalt des Festwertspeichers innerhalb der integrierten Schaltung mit von außen zugeführten Prüfdaten verglichen wird und bei Nichtübereinstimmung eine Fehlermeldung erzeugt wird, sowie eine Anordnung zur Durchführung des Verfahrens.

Ein derartiges Verfahren und eine entsprechende Anordnung sind bekannt aus der US-PS 4,777,586. Das im Festwertspeicher enthaltene Programm wird häufig vom Kunden selbst mit einem erheblichen Arbeitsaufwand ausgearbeitet, ggf. mit Unterstützung des Herstellers des Microcontrollers, und dieses Programm stellt somit einen erheblichen Wert dar. Um zu verhindern, daß ein Dritter sich einen derartigen Microcontroller beschafft und den Inhalt des ROM ausliest, um damit selbst Microcontroller zu bauen bzw. zu programmieren, wobei dieser Dritte dann den Aufwand für die Entwicklung des Programms sparen würde, muß das Prüfen des Inhalts des Festwertspeichers möglich sein, ohne daß dieser Inhalt von außen unmittelbar feststellbar ist.

Dies erfolgt nach der genannten US-PS 4,777,586 dadurch, daß der Inhalt des Festwertspeichers mit Hilfe eines gesondert erzeugten Taktsignals ausgelesen und einem gesonderten Vergleicher zugeführt wird, der mit der Invertierung dieses Taktsignals von außen zugeführte Prüfdaten empfängt. Ein Auftreten der Fehler wird gespeichert und nach einer vorgegebenen Anzahl von Prüfschritten über einen gesonderten Ausgang nach außen abgegeben. Für das Abzählen dieser Anzahl Prüfschritte ist ein gesonderter Zähler erforderlich. Der Vergleicher ist dabei mit Registern zum Zwischenspeichern der aus dem Festwertspeicher ausgelesenen Daten und der Prüfdaten versehen. Insgesamt sind also eine Vielzahl zusätzlicher Elemente für die Durchführung der Prüfung des Inhalts des Festwertspeichers erforderlich, die zusätzliche Fläche auf der integrierten Schaltung erfordern.

Aufgabe der Erfindung ist es daher, ein Verfahren der eingangs genannten Art anzugeben, mit dem die Prüfung des Inhalts des Festwertspeichers innerhalb der integrierten Schaltung mit möglichst geringen Änderungen, d.h. mit möglichst wenig Hardware durchgeführt werden kann.

Diese Aufgabe wird erfindungsgemäß dadurch gelöst, daß ein in einem Prüfprogrammspeicher gespeichertes Prüfprogramm vorgesehen ist, das im Prüfmodus des Prozessors aktiviert wird und bei dessen Ausführung durch den Prozessor der Inhalt des Festwertspeichers nacheinander ausgelesen und jeweils zusammen mit den entsprechenden von außen zugeführten Prüfdaten der Recheneinheit zum Vergleich zugeführt wird und eine auftretende Fehlermeldung im Speicherregister gespeichert wird, und daß diese Fehlermeldung erst am Ende des Prüfprogramms über einen im normalen Betrieb des Prozessors als Datenanschluß wirkenden Anschluß abgegeben wird.

Auf diese Weise ist nur ein kleiner zusätzlicher Speicher für das Prüfprogramm erforderlich, das nur einige wenige Befehle umfassen muß, während im übrigen für die Durchführung der Prüfung ausschließlich Elemente des Prozessors bzw. der integrierten Schaltung verwendet werden, die für den normalen Betrieb ohnehin vorhanden sind. Damit sind außer dem zusätzlichen Prüfprogrammspeicher praktisch keine Änderungen für die Durchführung der Prüfung innerhalb der integrierten Schaltung erforderlich, und auch zusätzliche Anschlüsse, insbesondere für die Fehlermeldung sind nicht erforderlich.

Grundsätzlich ist es ausreichend, eine Angabe darüber zu erhalten, ob der Inhalt des Festwertspeichers richtig ist oder ob überhaupt ein Fehler aufgetreten ist. Für manche Zwecke, beispielsweise für eine eventuelle Korrektur des Herstellungsverfahrens, ist es jedoch auch günstig zu wissen, ob viele Fehler im Inhalt des Festwertspeichers vorhanden sind. Nach einer Ausgestaltung des erfindungsgemäßen Verfahrens ist es daher zweckmäßig, daß jede aufgetretene Fehlermeldung zwischengespeichert und am Ende des Prüfprogramms eine Angabe über die Anzahl der Fehlermeldungen nach außen abgegeben wird. Diese Anzahl der Fehlermeldungen kann ebenfalls ohne zusätzlichem Hardware nur durch Programmschritte des Prozessors ermittelt, gespeichert und ausgegeben werden.

Eine Anordnung zur Durchführung des erfindungsgemäßen Verfahrens mit einer integrierten Schaltung, die einen Prozessor mit einer Recheneinheit und mindestens einem Speicherregister und einen Festwertspeicher sowie eine Anzahl äußerer Anschlüsse enthält, von denen wenigstens eine mit einer Prüfdaten liefernden Prüfanordnung verbunden sind, ist dadurch gekennzeichnet, daß in der integrierten Schaltung ein Prüfprogrammspeicher zur Aufnahme von Steuerbefehlen eines Prüfprogramms vorgesehen ist und daß der Prozessor nach Einstellung auf den Prüfmodus Steuerbefehle aus dem Prüfprogrammspeicher ausliest und durch diese Steuerbefehle gesteuert die Daten aus dem Festwertspeicher aufeinanderfolgend ausliest und zusammen mit den zugeführten Prüfdaten der Recheneinheit zum Vergleich zuführt und bei einem die Ungleichheit der zugeführten Daten anzeigenden Steuersignal der Recheneinheit den Inhalt des Speicherregisters gegenüber einem vorgegebenen Anfangszustand verändert und am Ende des Prüfprogramms den Inhalt des Speicherregisters einem im normalen Betrieb der integrierten Schaltung als Datenausgang wirkenden Anschluß zuführt.

Nach einer Ausgestaltung der erfindungsgemäßen Anordnung ist es zweckmäßig, daß der Prozessor bei jedem auftretenden Steuersignal der Recheneinheit den Inhalt des Speicherregisters als Dualzahl um eine Einheit erhöht. Dies kann durch entsprechende Befehle im Prüfprogramm realisiert werden.

Um die Änderungen üblicher Microcontroller zur Durchführung der erfindungsgemäßen Prüfung des ROM-Inhalts gering zu halten, ist es nach einer weiteren Ausgestaltung der Erfindung zweckmäßig, daß der Festwertspeicher und der Prüfprogrammspeicher über einen abhängig vom Prüfmodus und vom Ablauf des Prüfprogramms eingestellten Umschalter mit dem Prozessor verbunden sind. Auf diese Weise ist es einfach möglich, den Prozessor nacheinander durch den Prüfprogrammspeicher und durch den Festwertspeicher als eigentlichen Programmspeicher zu steuern. Der Umschalter besteht beispielsweise aus den am Ausgang der Speicher ohnehin vorhandenen Bus-Schalter.

Der Prüfprogrammspeicher kann in verschiedener Weise realisiert sein. Zweckmäßig ist es, daß der Prüfprogrammspeicher ein Festwertspeicher ist. Dessen Inhalt wird dann ebenso wie der Inhalt des Festwertspeichers für das Programm bei der Herstellung der integrierten Schaltung festgelegt und kann nicht mißbräuchlich verändert werden.

Es ist auch möglich, daß der Inhalt des Prüfprogrammspeichers fehlerhaft ist, wodurch ein Fehler im Inhalt des Festwertspeichers für das Programm vorgetäuscht werden kann, obwohl dieser tatsächlich korrekt ist und der Microcontroller somit funktionsfähig ist, da das Prüfprogramm im normalen Betrieb nicht verwendet wird. Es ist daher zweckmäßig, daß der Inhalt des Prüfprogrammspeichers von außerhalb der integrierten Schaltung zugänglich ist. Es wird dann also zunächst der Inhalt des Prüfprogrammspeichers geprüft, was in üblicher Weise mittels eines Vergleichs außerhalb der integrierten Schaltung durchgeführt werden kann, da der Inhalt des Prüfprogrammspeichers für Dritte keine wesentliche Bedeutung hat. Erst wenn das Prüfprogramm einwandfrei ist, kann dann die eigentliche Prüfung des Festwertspeichers für das Programm durchgeführt werden, so daß eine dann entstehende Fehlermeldung in jedem Falle auf einen Fehler im Inhalt des Programmspeichers zurückzuführen ist.

Ausführungsbeispiele der Erfindung werden nachstehend anhand der Zeichnung näher erläutert. Es zeigen:
- Fig. 1: ein schematisches Blockschaltbild der wesentlichen Teile einer erfindungsgemäßen Anordnung,
- Fig. 2: ein Flußdiagramm zur Erläuterung einer möglichen Durchführung des erfindungsgemäßen Verfahrens.

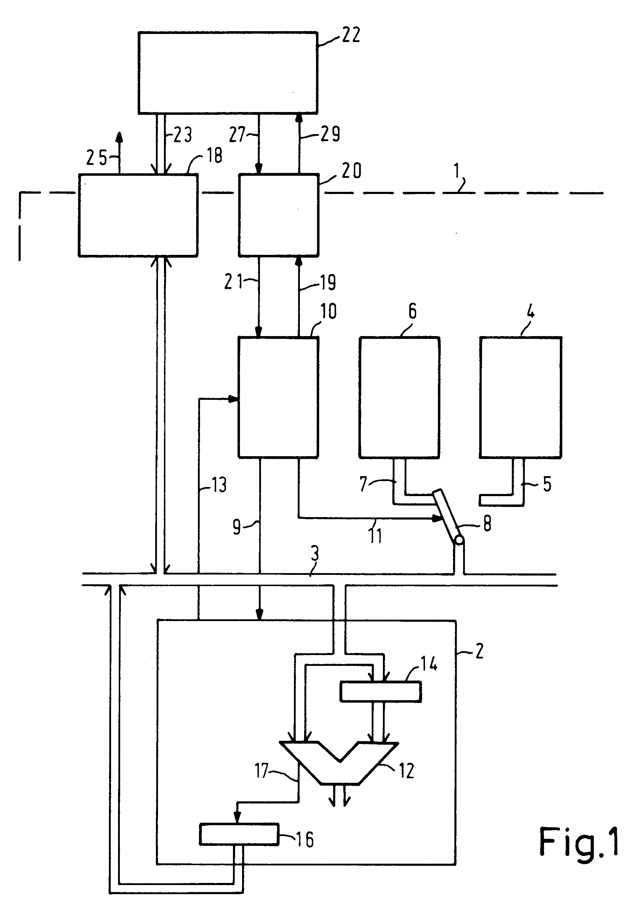

In Fig. 1 ist ein Microcontroller 1 angedeutet, der als monolithisch integrierte Schaltung aufgebaut ist und mit einer Prüfanordnung 22 verbunden ist. In dem Microcontroller 1 sind nur die für die folgende Erläuterung wichtigen Elemente dargestellt, während andere Elemente der Übersichtlichkeit halber weggelassen sind.

Ein wesentliches Element des Microcontrollers 1 ist der Prozessor 2, auch als CPU bezeichnet, der eine Anzahl Schaltungen enthält, von denen hier ebenfalls nur die für die folgende Erläuterung wichtigen Schaltungen dargestellt sind. Dies sind die arithmetisch-logische Verarbeitungsenheit 12, die allgemein als ALU bezeichnet ist. Ferner ist ein Register 14 angegeben, dessen Ausgang mit dem einen Dateneingang der ALU verbunden ist, während der andere Eingang der ALU 12 und der Eingang des Registers mit einem schematisch dargestellten internen Bus 3 verbunden sind. Ein Steuerausgang 17 der ALU 12, der ein Signal führt, wenn das Ergebnis der in der ALU 12 durchgeführten Verknüpfung ungleich Null ist, führt über hier nicht dargestelle, programmgesteuerte Schalter auf ein weiteres Register 16.

Ferner ist ein Programmspeicher 4 vorgesehen, der das vom Microcontroller im Normalbetrieb auszuführende Programm enthält und der als Festwertspeicher (ROM) ausgeführt ist, sowie ein weiterer Festwertspeicher 6, der das Prüfprogramm enthält. Der Ausgang 5 des ROM 4 und der Ausgang 7 des Prüfprogrammspeichers 6 sind wahlweise über einen Umschalter 8 mit dem internen Bus 3 verbindbar. Die Adressierung der Speicher 4 und 6 ist nicht gesondert dargestellt und erfolgt in üblicher Weise durch den Prozessor 2 über Adressenleitungen in dem Bus 3. Wenn das Prüfprogramm ohne Schleifen und Sprünge arbeitet, könnte der Prüfprogrammspeicher 6 jedoch auch durch einen gesonderten Adressengenerator, beispielsweise einen Zähler, angesteuert werden.

Die Steuerung des Umschalters 8, der als Multiplexer ausgeführt oder durch den Ausgängen der beiden Speicher 4 und 6 üblicherweise nachgeschaltete Bus-Datenschalter gebildet sein kann, erfolgt über die Leitung 11 durch eine Prüfsteuerschaltung 10, die den Prüfmodus in dem Microcontroller 1 steuert und die wiederum über die Leitung 13 von der CPU 2 beeinflußt wird. Eine derartige Prüfsteuerschaltung 10 ist in jedem Falle für die Prüfung der integrierten Schaltung 1 vorhanden, unabhängig von der beschriebenen Prüfung des Inhalts des ROM 4.

Der Microcontroller 1 ist für die Prüfung über die ohnehin vorhandenen Ein-Ausgangsschaltungen 18 und 20 mit einer Prüfanordnung 22 verbunden. Die Ein-Ausgangsschaltungen 18 und 20 enthalten für ausgehende Leitungen Treiberschaltungen und für eingehende Leitungen Empfangsschaltungen, die zumindest teilweise steuerbar bzw. schaltbar sind. Dies gilt insbesondere für die Ein-Ausgangsschaltungen 18, über die Datenwörter mit außen angeschlossenen Einrichtungen, in diesem Falle also mit der Prüfanordnung 22, ausgetauscht werden können. Die ausgehenden Datenleitungen sind in der Anordnung 18 häufig mit einem Register versehen, so daß diese Daten nur kurzzeitig vom Prozessor 2 erzeugt werden müssen und längere Zeit nach außen verfügbar sind.

Zur Durchführung der Prüfung wird nun von der Prüfanordnung 22 über die Leitung 27, die tatsächlich auch mehrere Leitungen umfassen kann, ein Signal zur Einstellung des Prüfmodus ausgesandt, das über die Ein-Ausgangsschaltung 20 und die Leitung 21 der Prüfsteuerschaltung 10 zugeführt wird. Vorher sind sowohl die Prüfanordnung 22 als auch der Microcontroller 1 über ein nicht dargestelltes Rücksetzsignal in eine Anfangsstellung gesetzt worden. Die Prüfsteuerschaltung 10 bringt nun über die Leitung 11 den Umschalter 8 in die dargestellte Stellung und führt damit den ersten Prüfbefehl aus dem Prüfprogrammspeicher 6 über den Bus 3 dem Prozessor 2 zu, wo er beispielsweise einem nicht dargestellten Befehlsregister gespeichert wird. Danach können ggf. noch weitere Befehle folgen, die den Prozessor 2 in einen gewünschten Zustand setzen. Statt dessen oder zusätzlich kann der Prozessor 2 auch noch über eine Verbindung 9 in den Prüfmodus gesetzt werden.

Danach schaltet die Prüfsteuerschaltung 10 kurzzeitig den Umschalter 8 um und führt das erste Datenwort aus dem ROM 4 über den Bus 3 dem Prozessor 2 zu, wo es im Register 14 zwischengespeichert wird und am einen Eingang der ALU 12 anliegt. Danach wird der Schalter 8 wieder in die dargestellte Lage zurückgeschaltet und ein von der Prüfanordnung 22 auf der Ausgangsleitung 23 erzeugtes Datenwort, das dem ersten richtigen Datenwort im ROM 4 entspricht, über die Ein-Ausgangsschaltung 18 und den Bus 3 dem anderen Eingang der ALU 12 zugeführt, und dann werden die beiden Datenwörter verglichen, beispielsweise durch Einstellen der ALU auf Subtraktion oder auf logische Vergleichsfunktion, sofern diese vorgesehen ist. Auf der Leitung 17 wird lediglich angezeigt, ob dabei Gleichheit oder Ungleichheit festgestellt worden ist. Im letzteren Falle, d.h. das erste Wort im ROM 4 stimmt nicht mit dem vorgegebenen Inhalt überein, wird das entsprechende Signal auf der Leitung 17 in das Register 16 eingeschrieben.

Nach dem Vergleich oder gleichzeitig damit wird die Adresse für den ROM 4 um 1 erhöht, und außerdem wird über die Leitung 13 der Prüfsteuerschaltung 10 ein Signal für das Ende eines Prüfschritts zugeführt, und daraufhin sendet die Prüfsteuerschaltung 10 über die Leitung 19 ein Synchronisiersignal aus, das über die Ein-Ausgangsschaltung 20 und die Leitung 29 der Prüfanordnung 22 zugeführt wird und dort den nächsten Vergleichswert auf der Leitung-23 bereitstellt. Ferner wird über die Leitung 11 wieder der Umschalter 8 auf die dargestellte Stellung umgeschaltet und der nächste Prüfschritt in gleicher Weise durchgeführt. Auf diese Weise wird der Inhalt des ROM 4 nacheinander mit entsprechenden Vergleichswerten der Prüfanordnung 22 verglichen. Wenn dabei mehrere Fehlersignale auf der Leitung 17 erzeugt werden, kann der Inhalt des Registers 16 als Dualzahl auch mittels entsprechender Steuerung durch die CPU 2 jeweils um einen Schritt erhöht werden.

Wenn schließlich die letzte, d.h. die höchste Adresse für den ROM 4 erzeugt worden ist, beendet die Prüfsteuerschaltung 10 die Prüfung und schaltet den Umschalter 8 endgültig in die nicht dargestellte Stellung, und außerdem wird der Inhalt des Registers 16, dessen Ausgang in üblicher Weise mit dem Bus 3 verbindbar ist, über die Ein-Ausgangsschaltung 18 an einem Ausgang 25 abgegeben. Dies ist üblicherweise ein Datenwort, in dem z.B. die Werte bestimmter Datenbits aussagen, ob während der Prüfung ein Fehlersignal aufgetreten ist oder nicht.

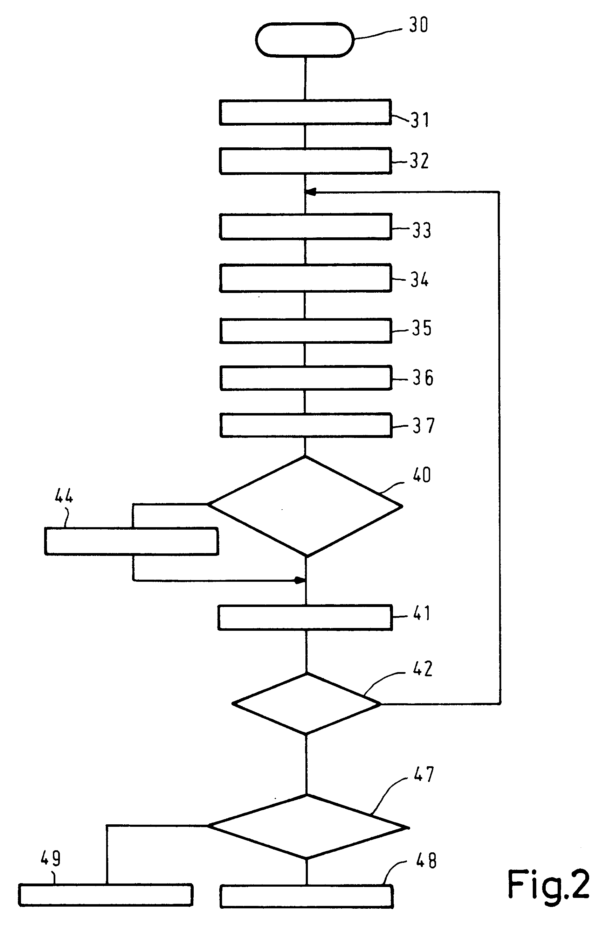

Dieser anhand der Anordnung in Fig. 1 beschriebene Ablauf des Prüfvorgangs wird nun in allgemeinerer Form anhand des Flußdiagramms in Fig. 2 erläutert.

Im Block 30 erfolgt das Rücksetzen der gesamten Anordnung, d.h. des Microcontrollers und der Prüfanordnung, auf einen definierten Anfangszustand. Im Block 31 wird ein Zähler in der Prüfanordnung 22, der nacheinander die Prüfdaten adressiert, auf die Anfangsstellung gesetzt, und im Block 32 wird die Adresse des ROM auf die Anfangsadresse gesetzt. Außerdem wird im Block 33 die ALU bzw. deren zugehöriges Akkumulatorregister auf Null gesetzt.

Im Block 34 wird über die Ein-Ausgangsschaltung ein Signal erzeugt, das die Prüfanordnung veranlaßt, die nächsten Prüfdaten dem Microcontroller zuzuführen. Im Block 35 wird die vom Prozessor adressierte Speicherstelle im ROM ausgelesen und dem Prozessor zugeführt, und im Block 36 werden die von der Prüfanordnung erzeugten Prüfdaten eingelesen. Im Block 37 wird vorbereitend die Adresse für den ROM um 1 erhöht.

Im Block 40 wird nun geprüft, ob die aus dem ROM gelesenen Daten (Block 35) mit den von der Prüfanordnung 22 zugeführten Daten (Block 36) übereinstimmen. Wenn dies nicht der Fall ist, wird im Block 44 ein Fehlerregister gesetzt bzw. ein Fehlerzähler weitergezählt und danach mit dem Block 41 weitergegangen, während bei Übereinstimmung beider Daten direkt zum Block 41 gegangen wird, bei dem das Signal am Ausgang des Microcontrollers, das Daten aus der Prüfanordnung 22 anfordert, zurückgesetzt wird. Schließlich wird im Block 42 geprüft, ob zuletzt die höchste Adresse des ROM ausgelesen worden ist, d.h. wegen des Blocks 37, ob die nächste vom Prozessor gelieferte Adresse größer ist als die höchste Adresse des ROM. Wenn dies nicht der Fall ist, wird zum Block 33 zurückgegangen und der Ablauf erneut wiederholt.

Wenn die letzte Adresse des ROM jedoch ausgelesen worden ist, wird im Block 47 geprüft, ob das Fehlerregister gesetzt bzw. der Fehlerzähler aus seiner Anfangsstellung gezählt worden ist. Wenn dies nicht der Fall ist, wird in vorher beschriebener Weise an einem Ausgang ein Datenwort erzeugt als Zeichen, daß die Prüfung beendet und kein Fehler aufgetreten ist, während bei einem gesetzten Fehlerregister bzw. einem weitergezählten Fehler im Block 49 ein anderes Datenwort am Ausgang des Microcontrollers erzeugt wird, das anzeigt, daß der ROM fehlerhaft ist. Damit ist der Prüfablauf abgeschlossen.

Statt der Prüfung im Block 47 kann auch nach dem Block 42 unbedingt der Inhalt des Fehlerregisters bzw. Fehlerzählers nach außen abgegeben werden, da dessen Inhalt unmittelbar angibt, ob ein Fehler aufgetreten ist.

## Patentansprüche

1. Verfahren zum Prüfen des Inhalts eines Festwertspeichers (4) in einer integrierten Schaltung (1), die ferner einen durch den Inhalt des Festwertspeichers (4) gesteuerten Prozessor (2) mit einer Recheneinheit (12) und einem Speicherregister (16) enthält, wobei der Prozessor (2) mit Außenanschlüssen (23-29) der integrierten Schaltung (1) verbunden ist und in einen Prüfmodus schaltbar ist, in dem der Inhalt des Festwertspeichers (4) innerhalb der integrierten Schaltung (1) mit von außen zugeführten Prüfdaten verglichen wird und bei Nichtübereinstimmung eine Fehlermeldung erzeugt wird, dadurch gekennzeichnet, daß ein in einem Prüfprogrammspeicher (6) gespeichertes Prüfprogramm vorgesehen ist, das im Prüfmodus des Prozessors (2) aktiviert wird und bei dessen Ausführung durch den Prozessor (2) der Inhalt des Festwertspeichers (4) nacheinander ausgelesen und jeweils zusammen mit den entsprechenden von außen zugeführten Prüfdaten der Recheneinheit (12) zum Vergleich zugeführt wird und eine auftretende Fehlermeldung im Speicherregister (16) gespeichert wird, und daß diese Fehlermeldung erst am Ende des Prüfprogramms über einen im normalen Betrieb des Prozessors (2) als Datenanschluß wirkenden Anschluß (25) abgegeben wird.

2. Verfahren nach Anspruch 1,
dadurch gekennzeichnet, daß jede aufgetretene Fehlermeldung zwischengespeichert und am Ende des Prüfprogramms eine Angabe über die Anzahl der Fehlermeldungen nach außen abgegeben wird.

3. Anordnung zur Durchführung des Verfahrens nach Anspruch 1 oder 2 mit einer integrierten Schaltung (1), die einen Prozessor (2) mit einer Recheneinheit (12) und mindestens einem Speicherregister (16) und einen Festwertspeicher (4) sowie eine Anzahl äußerer Anschlüsse (23-29) enthält, von denen wenigstens eine mit einer Prüfdaten liefernden Prüfanordnung (22) verbunden sind,
dadurch gekennzeichnet, daß in der integrierten Schaltung (1) ein Prüfprogrammspeicher (6) zur Aufnahme von Steuerbefehlen eines Prüfprogramms vorgesehen ist und daß der Prozessor (2) nach Einstellung auf den Prüfmodus Steuerbefehle aus dem Prüfprogrammspeicher (6) ausliest und durch diese Steuerbefehle gesteuert die Daten aus dem Festwertspeicher (4) aufeinanderfolgend ausliest und zusammen mit den zugeführten Prüfdaten der Recheneinheit (12) zum Vergleich zuführt und bei einem die Ungleichheit der zugeführten Daten anzeigenden Steuersignal der Recheneinheit (12) den Inhalt des Speicherregisters (16) gegenüber einem vorgegebenen Anfangszustand verändert und am Ende des Prüfprogramms den Inhalt des Speicherregisters (16) einem im normalen Betrieb der integrierten Schaltung (1) als Datenausgang wirkenden Anschluß (25) zuführt.

4. Anordnung nach Anspruch 3,
dadurch gekennzeichnet, daß der Prozessor (2) bei jedem auftretenden Steuersignal der Recheneinheit (12) den Inhalt des Speicherregisters (16) als Dualzahl um eine Einheit erhöht.

5. Anordnung nach Anspruch 3 oder 4,
dadurch gekennzeichnet, daß der Festwertspeicher (4) und der Prüfprogrammspeicher (6) über einen abhängig vom Prüfmodus und dem Ablauf der Prüfung eingestellten Umschalter (8) mit dem Prozessor (2) verbunden sind.

6. Anordnung nach einem der Ansprüche 3 bis 5,
dadurch gekennzeichnet, daß der Prüfprogrammspeicher (6) ein Festwertspeicher ist.

7. Anordnung nach einem der Ansprüche 3 bis 6,
dadurch gekennzeichnet, daß der Inhalt des Prüfprogrammspeichers (6) von außerhalb der integrierten Schaltung (1) zugänglich ist.

## Claims

1. A method of testing the contents of a read-only memory (4) in an integrated circuit (1) which also comprises a processor (2) which is controlled by the contents of the read-only memory (4) and comprises an arithmetic unit (12) and a storage register (16), the processor (2) being connected to external connections (23-29) of the integrated circuit (1) and being switchable to a test mode in which the contents of the read-only memory (4) in the integrated circuit (1) are compared with externally supplied test data, an error message being generated in the case of non-correspondence, characterized in that there is provided a test program which is stored in a test program memory (6) and which is activated in the test mode of the processor (2), in that upon execution of said test program by the processor (2) the contents of the read-only memory (4) are successively read and applied each time together with the corresponding, externally supplied test datal to the arithmetic unit (12) for comparison, an error message occurring being stored in the storage register (16) and being output only at the end of the test program, via a connection (25) which acts as a data connection during normal operation of the processor. (2)

2. A method as claimed in Claim 1, characterized in that each error message occurring is temporarily stored, and in that at the end of the test program a message concerning the number of error messages is output to the environment.

3. A device for performing the method claimed in Claim 1 or 2, comprising an integrated circuit (9) which comprises a microprocessor (2) having an arithmetic unit (12) and at least one storage register (16) and one read-only memory (4) as well as a number of external connections (23-29), at least one of which is connected to a test device (22) supplying test data, characterized in that the integrated circuit (1) comprises a test program memory (6) for storing control instructions of a test program, in that, after having been switched to the test model the processor (2) reads control instructions from the test program memory (6) and successively reads, under the control of these control instructions, the data from the read-only memory (4) and applies this data, together with the test data supplied, to the arithmetic unit (12) for comparison, and in that in the case of a control signal indicating non-correspondence of the supplied data the arithmetic unit (12) modifies the contents of the storage register (16) with respect to a predetermined initial state and applies, at the end of the test program, the contents of the storage register (16) to a connection (25) which acts as a data output during normal operation of the integrated circuit (1).

4. A device as claimed in Claim 3, characterized in that for each control signal of the arithmetic unit (12) occurring the processor (2) increments the contents of the storage register (16), being a binary number, by one unit.

5. A device as claimed in Claim 3 or 4, characterized in that the read-only memory (4) and the test program memory (6) are connected to the processor (2) via a switch (8) which is switched in dependence on the test mode and on the progress of the test.

6. A device as claimed in any one of the Claims 3 to 5, characterized in that the test program memory (6) is a read-only memory.

7. A device as claimed in any one of the Claims 3 to 6, characterized in that the contents of the test program memory (6) are accessible from outside the integrated circuit (1).

## Revendications

1. Procédé de contrôle du contenu d'une mémoire morte (4) dans un circuit intégré (1), qui contient en outre un processeur (2) commandé par le contenu de la mémoire morte (4) comportant une unité de calcul (12) et une unité de mémoire (16), le processeur (2) étant connecté aux connexions externes (23, 29) du circuit intégré (1) et pouvant être commuté dans un mode de contrôle dans lequel le contenu de la mémoire morte (4) à l'intérieur du circuit intégré (1) est comparé à des données de contrôle acheminées de l'extérieur et, en cas de non-coïncidence, un message d'erreur est produit, caractérisé en ce qu'il est prévu un programme de contrôle mémorisé dans une mémoire de programme de contrôle (6) qui est activée dans le mode de contrôle du processeur (2) et, lors de son exécution, le contenu de la mémoire morte (4) est extrait par le processeur (2) successivement et est chaque fois acheminé à l'unité de calcul (12) conjointement avec les données de contrôle correspondantes acheminées de l'extérieur, pour comparaison et un message d'erreur qui apparaît est mémorisé dans le registre de mémoire (16), ce message d'erreur n'étant délivré qu'à la fin du programme du contrôle via une connexion (25) jouant le rôle de connexion de données au cours d'un fonctionnement normal du processeur (2).

2. Procédé selon la revendication 1, caractérisé en ce que chaque message d'erreur apparaissant fait l'objet d'un stockage intermédiaire et, à la fin du programme de contrôle, une indication du nombre de messages d'erreur est délivrée à l'extérieur.

3. Agencement pour l'exécution du procédé selon la revendication 1 ou 2 avec un circuit intégré (1) qui contient un processeur (2) comportant une unité de calcul (12) et au moins un registre de mémoire (16) et une mémoire morte (4) ainsi qu'un certain nombre de connexions externes (23-29), dont au moins une est connectée à un dispositif de contrôle (22) fournissant des données de contrôle, caractérisé en ce que, dans le circuit intégré (1), il est prévu une mémoire de programme de contrôle (6) pour recevoir des instructions de commande d'un programme de contrôle et le processeur (2), après réglage sur le mode de contrôle, extrait les instructions de commande de la mémoire de programme de contrôle (6) et, sous la commande de ces instructions de commande, extrait les données de la mémoire morte (4) successivement et, conjointement avec les données de contrôle acheminées, les envoie à l'unité de calcul (12) pour comparaison et, dans le cas d'un signal de commande de l'unité de calcul (12) indiquant l'inégalité des données acheminées, modifie le contenu du registre de stockage (16) par rapport à un état de départ prédéterminé et envoie, à la fin du programme de contrôle, le contenu du registre de stockage (16) à une connexion (25) jouant le rôle de sortie de données au cours de l'exploitation normale du circuit intégré (1).

4. Agencement selon la revendication 3, caractérisé en ce que le processeur (2) augmente le contenu du registre de stockage (16) d'une unité sous la forme d'un nombre binaire à chaque apparition d'un signal de commande de l'unité de calcul (12).

5. Agencement selon la revendication 3 ou 4, caractérisé en ce que la mémoire morte (4) et la mémoire de programme de contrôle (6) sont connectées au processeur (2) via un commutateur (8) réglé en fonction du mode de contrôle et du déroulement du contrôle.

6. Agencement selon l'une quelconque des revendications 3 à 5, caractérisé en ce que la mémoire de programme de contrôle (6) est une mémoire morte.

7. Agencement selon l'une quelconque des revendications 3 à 6, caractérisé en ce que le contenu de la mémoire de programme de contrôle (6) est accessible de l'extérieur du circuit intégré (1).
